# EUROPÄISCHE PATENTSCHRIFT

(11) **EP 1 921 656 B1**
(45) Veröffentlichungstag und Bekanntmachung des Hinweises auf die Patenterteilung: **30.04.2014**
(21) Anmeldenummer: 07017531.0
(22) Anmeldetag: 07.09.2007
(51) Int. Cl.: H01J 37/32, C23C 16/515, C23C 16/511, C23C 16/52, C23C 16/40, C23C 16/505

(54) **Verfahren und Vorrichtung zur plasmaunterstützten chemischen Dampfphasenabscheidung**
Method and device for plasma-aided chemical vapour deposition
Procédé et dispositif de dépôt chimique en phase vapeur assisté de plasma

(30) Priorität: 10.11.2006 DE 102006053366
(43) Veröffentlichungstag der Anmeldung: 14.05.2008
(73) Patentinhaber: Schott AG, 55122 Mainz (DE)
(72) Erfinder: Moelle, Christoph Dr., 55131 Mainz (DE); Bewig, Lars Dr., 37581 Bad Gandersheim (DE); Küpper, Thomas, 37581 Bad Gandersheim (DE); Brandt, Lars, 37547 Kreiensen (DE); Niklos, Thomas, 64347 Griesheim (DE)
(74) Vertreter: Herden, Andreas F.

(56) Entgegenhaltungen:
- EP-A- 1 561 840
- DE-C1- 4 114 108
- US-A- 5 395 453
- US-A- 5 562 952

## Beschreibung

Die Erfindung betrifft allgemein plasmaunterstützte chemische Dampfphasenabscheidung, insbesondere die plasmaunterstützte chemische Dampfphasenabscheidung mittels gepulster Plasmen.

Aus der EP 0 522 281 A1 sind ein Verfahren und eine Vorrichtung bekannt, bei welchen gepulste Mikrowellen verwendet werden, um ein gepulstes Plasma zu erzeugen. Das Zünden des Plasmas zu Beginn eines Pulses wird dabei durch einen Hochspannungspuls oder durch eine Überhöhung des Mikrowellenpulses unterstützt.

Durch das gezündete Plasma, welches während der Pulsdauer mit der entsprechenden Leistung des Mikrowellen-Generators aufrechterhalten wird, kann es jedoch zu einer Aufheizung des zu beschichtenden Substrats, insbesondere von dessen Oberfläche kommen, welche die Produkteigenschaften temperaturempfindlicher Substrate negativ beeinflussen kann. So kann es beispielsweise bei thermoplastischen Kunststoffsubstraten zu einer Erweichung der Oberfläche kommen. Auch ist die Leistungsregelung der Mikrowellen aufwendig, insbesondere wenn es auf genaue Schichtdicken ankommt, denn die Menge des im Verlauf eines Pulses abgeschiedenen Materials wird neben der Länge der Pulse auch durch dessen Leistung bestimmt.
Die US 5,562,952 A lehrt eine CVD-Methode zur Abscheidung von Dünnschichten und eine dazu geeignete Vorrichtung. Gepulste Hochfrequenzenengerie, deren Frequenz und Amplitude geregelt wird, dient zur Zündung des Plasmas.

Die Patentschrift DE 41 14 108 C1 beschreibt ein Verfahren und eine Vorrichtung zur Plasma-Beschichtung von Substanzen. Das streifenförmige Plasma wird mittels zweier senkrecht zueinander polarisierter, stehender Wellen angeregt. Der Energieeintrag erfolgt gepulst, wobei die beiden Mikrowellenquellen sich während einer Pulsfolge abwechseln, so dass innerhalb einer Pulsfolge immer eine Quelle aktiv ist. Mit diesem Verfahren wird eine sehr gleichmäßige Plasma-Ausbildung erreicht.

Die EP 1 561 840 A1 lehrt eine Methode für die Herstellung von Metalloxid-Filmen mittels der Verwendung einer Mikrowellenquelle. Die Mikrowellenenergie wird sowohl hinsichtlich der Frequenz als auch hinsichtlich der Amplitude streng geregelt.

Der Erfindung liegt daher die Aufgabe zugrunde, die oben genannten Probleme zu lösen. Diese Aufgabe wird bereits in höchst überraschend einfacher Weise durch den Gegenstand der unabhängigen Ansprüche gelöst. Vorteilhafte Ausgestaltungen und Weiterbildungen der Erfindung sind in den abhängigen Ansprüchen angegeben.

Demgemäß sieht die Erfindung ein Verfahren zur Beschichtung von Substraten mittels plasmaunterstützter Dampfphasenabscheidung vor, wobei wenigstens ein Teil der Umgebung der Substratoberfläche eines zu beschichtenden Substrats evakuiert und ein Prozessgas mit einer Ausgangssubstanz für die Beschichtung eingelassen wird, wobei die Beschichtung abgeschieden wird, indem durch Einstrahlung elektromagnetischer Energie in der Umgebung der Substratoberfläche, die mit dem Prozessgas ausgefüllt ist, ein Plasma gezündet wird. Dabei wird die elektromagnetische Energie in Form einer Vielzahl von Pulsfolgen mit einer Vielzahl von zeitlich durch erste Pausen beabstandeten Pulsen eingestrahlt, wobei in den Pausen die eingestrahlte elektromagnetische Energie abgeschaltet wird, und wobei die Pausen zwischen den Pulsfolgen zumindest einen Faktor 3, vorzugsweise zumindest einen Faktor 5 länger sind als die ersten Pausen zwischen den Pulsen innerhalb einer Pulsfolge.

Eine entsprechende Vorrichtung zur Beschichtung von Substraten mittels plasmaunterstützter Dampfphasenabscheidung, mit welcher das vorstehend beschriebene Verfahren ausgeführt werden kann, umfasst wenigstens einen Reaktor mit einer Einrichtung, um wenigstens einen Teil der Umgebung der Substratoberfläche eines zu beschichtenden Substrats zu evakuieren und ein Prozessgas mit einer Ausgangssubstanz für die Beschichtung einzulassen. Die Vorrichtung weist weiterhin eine Quelle für gepulste elektromagnetische Energie auf, welche an den Reaktor angekoppelt ist, um durch Einstrahlung elektromagnetischer Energie in der Umgebung der Substratoberfläche, die mit dem Prozessgas ausgefüllt ist, ein Plasma zu zünden und eine Beschichtung abzuscheiden. Eine Steuereinrichtung ist vorgesehen, mit welcher die Quelle so gesteuert wird, daß die elektromagnetische Energie in Form einer Vielzahl von Pulsfolgen mit einer Vielzahl von zeitlich durch erste Pausen beabstandeten Pulsen eingestrahlt wird, wobei die Quelle in den ersten Pausen inaktiv geschaltet wird und wobei die Pausen zwischen den Pulsfolgen zumindest einen Faktor 3, vorzugsweise zumindest einen Faktor 5 länger sind als die Pausen zwischen den Pulsen innerhalb einer Pulsfolge.

Die Erfindung basiert demgemäß darauf, daß anstelle einer periodischen Überhöhung von Mikrowellenpulsen durch Zündpulse, wie sie aus der EP 0 522 281 A1 bekannt sind, nun die Zündpulse alleine für die Plasmaerzeugung genutzt werden. Ebenso wie bei der EP 0 522 281 A1 werden mittels einer entsprechenden gepulst betriebenen Quelle vorzugsweise gepulste Mikrowellen eingesetzt. Ebenso geeignet ist eine gepulst betriebene Hochfrequenz-Quelle.

Unter dem Begriff Mikrowellen werden im Sinne der Erfindung insbesondere nicht nur Mikrowellen im wörtlichen Sinne, also elektromagnetische Wellen mit Wellenlängen im Mikrometerbereich, sondern auch elektromagnetische Wellen mit Frequenzen ab 1 GHz bezeichnet. Der Begriff einer Mikrowelle umfasst demgemäß auch die Frequenzen, die für Haushalts-Mikrowellengeräte eingesetzt werden. Eine geeignete Mikrowellen-Frequenz ist daher auch eine Frequenz von 2,45 GHz, wie sie verbreitet in Haushalts-Mikrowellengeräten eingesetzt wird. Um die Mikrowellen oder die Hochfrequenzstrahlung zu erzeugen ist unter anderem eine Quelle mit einem Magnetron geeignet.

Da die elektromagnetischen Pulse, wie sie sonst für die plasmaimpuls-induzierte chemische Dampfphasenabscheidung (PICVD) eingesetzt werden, erfindungsgemäß in eine Folge kurzer Zündpulse aufgespalten werden, wird die Aufheizung des Substrats auf ein Minimum reduziert. Da die einzelnen Pulse einer Pulsfolge in ihrer Pulshöhe insbesondere wie die aus der EP 0 522 281 A1 bekannten Zündpulse erzeugt werden, wird darüber hinaus dennoch eine sichere Zündung des Plasmas erreicht. Die längeren Pulspausen zwischen den einzelnen Pulsfolgen dienen dann dem möglichst vollständigen Austausch des Prozessgases. Damit wird gleichzeitig die Anreicherung von im Plasma entstehenden unerwünschten Reaktionsprodukten vermieden. Es wird diesbezüglich nicht ausgeschlossen, daß zwischen den Zündpulsen innerhalb einer Pulsfolge noch eine gewisse elektromagnetische Leistung eingekoppelt wird, jedoch wird die Quelle so betrieben, daß eine solche Leistung unterhalb der Schwelle für die Aufrechterhaltung des Plasmas liegt. Damit soll insbesondere vermieden werden, daß durch Aufrechterhaltung des Plasmas zwischen den Pulsen innerhalb einer Pulsfolge eine weitergehende Erwärmung des Substrats erfolgt.

Ein weiterer Vorteil der Erfindung liegt darin, daß auf eine aufwendige Leistungsregelung verzichtet werden kann, da ohnehin eine Plasmaerzeugung nur mit den im allgemeinen schlecht regelbaren Zündpulsen erfolgt. So ist in Weiterbildung der Erfindung vorgesehen, daß die Pulsleistung ungeregelt eingekoppelt wird. Es kann demgemäß also eine Quelle mit ungeregelter Leistungsabgabe verwendet werden. Dies vereinfacht eine derartige Vorrichtung gegenüber bekannten Plasmabeschichtungsanlagen, bei welchen die Leistungsabgabe, beispielsweise durch eine Spannungs- oder Stromregelung im Magnetron auf vorgegebene Werte eingeregelt wird, beträchtlich.

Unabhängig davon, ob eine Leistungsregelung vorgenommen wird, oder nicht, kann dennoch eine genaue Kontrolle bezüglich der Menge des abgeschiedenen Materials erfolgen. So wird dazu die Pulsleistung oder zumindest eine von der Pulsleistung abhängige Größe gemessen und über die einzelnen Pulse zeitlich integriert, wobei die Pulsfolge mittels einer Steuereinrichtung abgebrochen wird, wenn die integrierte Pulsleistung einen vorbestimmten Schwellwert überschreitet. Nach einer Pause vorbestimmter Länge, wie oben angegeben, kann dann die nächste Pulsfolge gestartet werden. Die Vorrichtung ist dazu mit einer Meßeinrichtung ausgestattet, mit welcher dementsprechend die Pulsleistung oder zumindest eine von der Pulsleistung abhängige Größe gemessen wird, wobei die Steuereinrichtung dazu ausgebildet ist, die Meßwerte über die einzelnen Pulse zeitlich zu integrieren und die Pulsfolge abzubrechen, wenn die integrierte Pulsleistung einen vorbestimmten Schwellwert überschreitet und nach einer Pause vorgegebener Länge die nächste Pulsfolge zu starten. Die über die Pulse integrierte Meßgröße liefert damit einen Wert für die insgesamt im Plasma deponierte Energie.

Eine Möglichkeit dazu ist, die an einem Wellenleiter zur Einkopplung der elektromagnetischen Energie ausgekoppelte Feldstärke zu messen und über die einzelnen Pulse zeitlich zu integrieren. Um die ausgekoppelte Feldstärke zu messen, kann die Meßeinrichtung einen Sensor umfassen, welcher an den Wellenleiter zur Einkopplung der elektromagnetischen Energie die ausgekoppelte Feldstärke oder Leistung misst.

Eine weitere, alternative oder zusätzliche Möglichkeit besteht darin, die Intensität der Lichtemission des Plasmas zu und zeitlich zu integrieren. Die Pulsfolge kann dann abgebrochen werden, wenn die zeitlich integrierte Lichtemission einen vorgegebenen Schwellwert überschreitet. Entsprechend ist dazu eine Einrichtung zur Messung der Lichtintensität des Plasmas vorgesehen, wobei die Steuereinrichtung eingerichtet ist, eine Pulsfolge abzubrechen, wenn die zeitlich integrierte Intensität der Lichtemission einen vorgegebenen Schwellwert überschreitet. Die Einrichtung zur Messung der Lichtintensität muß dabei nicht die gesamte Strahlungsintensität erfassen. Vielmehr kann diese auch dazu ausgebildet sein, spektral selektiv die Intensität bestimmter Anteile des emittierten Spektrums zu messen. So kann etwa bei der Abscheidung von Siliziumoxid-Schichten die Lichtintensität einer für Silizium charakteristischen Spektrallinie des Plasmas gemessen werden. Da die Erfindung, ähnlich wie auch andere PICVD-Prozesse insbesondere für die Abscheidung von Oxidschichten geeignet ist, kann auch die Intensität charakteristischer Linien von Sauerstoff selektiv erfasst werden.

Eine weitere, alternative oder zusätzliche Möglichkeit, den Abscheideprozess zu regeln, liegt darin, die Pulsleistung oder zumindest eine von der Pulsleistung abhängige Größe zu messen und über die einzelnen Pulse zeitlich zu integrieren. Anhand der so gemessenen Größen kann dann die Länge der Pausen zwischen den Pulsfolgen mittels einer Steuereinrichtung angepasst werden. Auch auf diese Weise kann die mittlere Leistung pro Zeiteinheit, gemittelt über mehrere Pulsfolgen, eingestellt werden.

Da der erfindungsgemäße Betrieb mittels durch längere Pausen getrennte Pulsfolgen von durch kürzere Pausen getrennten kurzen Pulsen besonders geeignet dazu ist, die Substrataufheizung zu minimieren, kann umgekehrt auch die Substrattemperatur selbst als Steuerparameter für den Abscheideprozess verwendet werden. Dazu kann mittels einer entsprechend eingerichteten Steuereinrichtung die Substrattemperatur erfasst und anhand des erfassten Temperaturwerts die Länge der Pulsfolgen oder das Verhältnis der Längen von Pausen zwischen den Pulsfolgen und der Länge der Pulsfolge angepasst werden. Im speziellen ist es dabei sinnvoll, wenn die Länge der Pulsfolgen verkürzt oder das Verhältnis von Länge der Pulsfolgen zu Länge der Pulspausen zwischen den Pulsfolgen verkleinert wird, wenn die Substrattemperatur über einem vorgegebenen Wert liegt und/oder die Länge der Pulsfolge verlängert oder das Verhältnis von Länge der Pulsfolgen zu Länge der Pulspausen zwischen den Pulsfolgen vergrößert wird, wenn die Substrattemperatur unter einem vorgegebenen Wert liegt.

Die einzelnen Zündpulse werden besonders bevorzugt zur Reduktion der Aufheizung des Substrats deutlich kürzer gehalten als die Länge der Pulsfolge. Insbesondere ist es dazu günstig, wenn die Pulse in den Pulsfolgen eine Dauer haben, die kürzer als 1/10 der Dauer einer Pulsfolge ist. Übliche Pulse, die bei PICVD-Beschichtungsverfahren eingesetzt werden, weisen weiterhin Pulslängen im Bereich von Millisekunden auf. Erfindungsgemäß werden nun derartige Pulse in eine Vielzahl von deutlich kürzeren, als Zündpulse ausgebildete Pulse aufgespalten. So werden vorzugsweise Pulse in den Pulsfolgen mit einer Dauer von höchstens 5 Mikrosekunden, oder sogar nur höchstens 2 Mikrosekunden eingesetzt.

Die Erfindung wird nachfolgend anhand von Ausführungsbeispielen und unter Bezugnahme auf die beigeschlossenen Zeichungen näher erläutert. Es zeigen:
Fig. 1 eine Pulsform mit periodischen Pulsüberhöhungen, wie sie aus dem Stand der Technik bekannt ist,
Fig. 2 ein Diagramm von Pulsfolgen mit einer Abfolge von Pulsen gemäß der Erfindung, und
Fig. 3 eine schematische Darstellung einer Vorrichtung zur Beschichtung von Substraten mittels plasmaimpuls-induzierter chemischer Dampfphasenabscheidung unter Verwendung von Pulsfolgen, wie sie in Fig. 2 dargestellt sind.

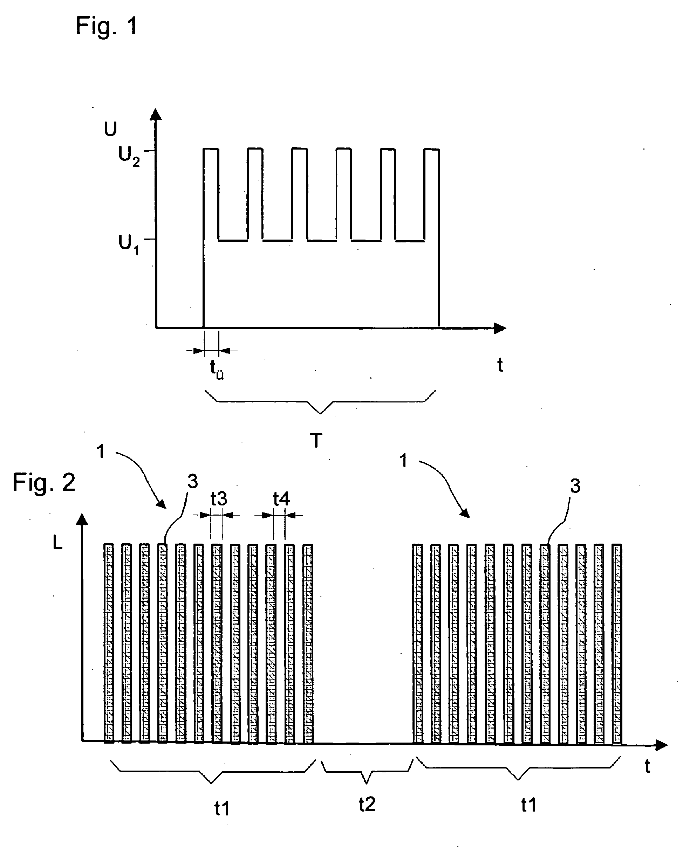

In Fig. 1 ist ein Mikrowellenimpulsdiagramm eines Pulses dargestellt, wie er gemäß der EP 0 522 281 A1 aus dem Stand der Technik bekannt ist. Einem Mikrowellenpuls der Höhe U₁ und der Dauer T sind periodische Pulsüberhöhungen der Höhe U₂ und der kürzeren Dauer t_{ü} überlagert. Mittels der periodischen Impulsüberhöhungen wird das Plasma gezündet und durch die Intensität des Pulses zwischen den Überhöhungen aufrechterhalten.

Fig. 2 zeigt ein Diagramm von Mikrowellenpulsen, wie sie erfindungsgemäß eingesetzt werden. Dabei ist die Leistung L der Pulse als Funktion der Zeit t aufgetragen.

Die Pulse werden in den Reaktor in Form von Pulsfolgen mit einer Dauer t1 eingestrahlt. Jede der Pulsfolgen 1 der Dauer t1 ist unterteilt in einzelne Zündpulse 3 der Dauer t3, wobei zwischen den Zündpulsen 3 die Mikrowellenleistung jeweils für eine Dauer t4 unterbrochen oder abgeschaltet wird. Die einzelnen Pulsfolgen 1 sind durch Pausen der Dauer t2 unterbrochen. Dabei ist die Dauer t2 der Pausen zwischen den Pulsfolgen 1 um zumindest einen Faktor 3, vorzugsweise zumindest einen Faktor 5 länger als die Dauer t4 der Pausen zwischen aufeinanderfolgenden Pulsen 3 innerhalb einer Pulsfolge 1. Die Mikrowellenleistung zwischen den einzelnen Pulsen 3 innerhalb einer Pulsfolge 1 ist vorzugsweise verschwindend. Sofern aber noch, beispielsweise durch die Abschaltcharakteristik eines Magnetrons als Quelle eine gewisse Mikrowellenleistung in den Pulspausen der Länge t4 vorhanden ist, ist diese niedriger, als die für die Aufrechterhaltung des Plasmas zwischen den Pulsfolgen erforderliche Schwell-Leistung.

Die Pulse 3 sind insbesondere auch wesentlich kürzer als die Dauer der Pulsfolge. Vorzugsweise ist die Dauer t3 dabei mit Pulsdauern von höchstens 5 Mikrosekunden, oder sogar höchstens 2 Mikrosekunden um mindestens einen Faktor 10 kürzer als die Dauer t1.

Die Pulsleistung der einzelnen Pulse 3 ist in Fig. 2 als gleich hoch für alle Pulse dargestellt. In der Praxis können die Pulsleistungen jedoch variieren, insbesondere wenn eine ungeregelte Mikrowellen-Quelle eingesetzt wird, die jeweils zur Erzeugung der Pulse 3 immer nur ein- und ausgeschaltet wird.

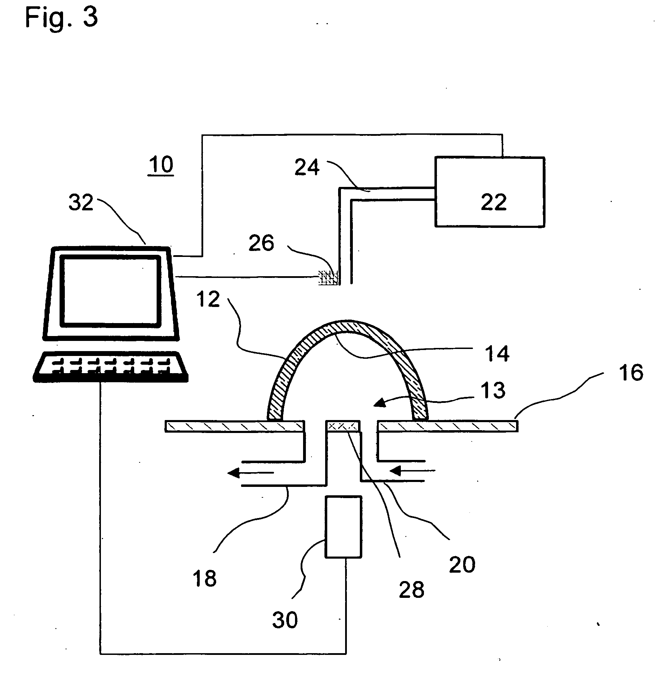

Fig. 3 zeigt eine schematische Darstellung einer Vorrichtung 10 zur Beschichtung von Substraten mittels Plasmaimpuls-induzierter chemischer Dampfphasenabscheidung unter Verwendung von Pulsfolgen, wie sie in Fig. 2 dargestellt sind. Die Vorrichtung 10 ist beispielhaft zur Beschichtung der innenseitigen Oberfläche 14 von Substraten 12 in Form von Scheinwerferkalotten ausgebildet. Die Kalotte 12 wird dazu auf eine Dichtfläche 16 aufgesetzt, so daß die Innenfläche 14 gegenüber der Umgebung abgedichtet wird. Mittels einer Pumpe wird über eine Ableitung 18 das so geschaffene Volumen 13, welches die Innenfläche 14 umgibt, evakuiert. Über eine Zuleitung 20 wird Prozessgas mit den Ausgangsstoffen der abzuscheidenden Schicht in das abgeschlossene Volumen 13 eingeleitet. Mittels einer Mikrowellen-Quelle 22 werden über einen Hohlleiter 24 die Mikrowellen zur Kalotte 12 geleitet. Die in das Volumen 13 über den Hohlleiter eingekoppelten Mikrowellen verursachen die Zündung eines Plasmas im Volumen 13. Dadurch werden im Plasma Reaktionsprodukte erzeugt, die sich auf der Innenseite 14 der Kalotte 13 als Beschichtung niederschlagen. Als gasförmige Ausgangsstoffe können beispielsweise ein Silizium-Precursor und ein Titan-Precursor gemischt mit Sauerstoff im Wechsel eingelassen werden, um Titanoxid-Siliziumoxid-Wechselschichten zu erzeugen. Diese Wechselschichten können dann als Interferenzschichtsystem zur Beeinflussung der optischen Eigenschaften der Kalotte 12 dienen.

Als Silizium-Precursor ist allgemein beispielsweise HMDSO (Hexamethyldisiloxan) geeignet. Zur Abscheidung von Titanoxid-Schichten eignet sich insbesondere Titanchlorid (TiCl₄). Das abgeschiedene Wechselschichtsystem kann beispielsweise eine Kaltlicht-Reflektorschicht sein.

Die Mikrowellen-Quelle 22 wird gepulst betrieben, wobei die Quelle 22 so geschaltet wird, daß eine wie in Fig. 2 beispielhaft schematisch dargestellte Pulsfolgen-Form erzeugt wird. Die Schaltung der Mikrowellen-Quelle erfolgt dabei mittels einer Steuereinrichtung 32, welche die Quelle 22 dementsprechend so schaltet, daß eine Vielzahl von zeitlich durch erste Pausen beabstandeten Pulsen eingestrahlt wird, wobei in den Pausen die eingestrahlte elektromagnetische Energie abgeschaltet wird, und wobei die Pausen zwischen den Pulsfolgen zumindest einen Faktor 3, vorzugsweise zumindest einen Faktor 5 länger sind als die ersten Pausen zwischen den Pulsen innerhalb einer Pulsfolge.

Zusätzlich vorgesehen ist eine Meßeinrichtung 30, welche durch ein Fenster 28 hindurch die Intensität der Lichtemission des Plasmas mißt. Die Meßwerte werden dann von der Steuereinrichtung zeitlich integriert. Wird ein vorgegebener Schwellwert für die integrierte Intensität überschritten, wird die Pulsfolge abgebrochen. Damit wird sichergestellt, daß die vorgegebene Schichtdicke erreicht ist. Alternativ oder zusätzlich kann auch die Länge der Pausen zwischen den Pulsfolgen angepasst werden.

Die Meßeinrichtung kann alternativ oder zusätzlich ausgebildet sein, die Temperatur der Substratoberfläche bestimmen, zum Beispiel über eine pyrometrische Messung. Je nach Substrattemperatur kann dann die Länge der Pausen oder das Verhältnis von Pausen zwischen den Pulsfolgen und der Dauer der Pulsfolgen angepasst werden. Hierbei ist es sinnvoll, wenn mittels der Steuereinrichtung 32 die Länge der Pulsfolgen verkürzt oder das Verhältnis von Länge der Pulsfolgen zu Länge der Pulspausen zwischen den Pulsfolgen verkleinert wird, wenn die Substrattemperatur über einem vorgegebenen Wert liegt und/oder die Länge der Pulsfolge verlängert oder das Verhältnis von Länge der Pulsfolgen zu Länge der Pulspausen zwischen den Pulsfolgen vergrößert wird, wenn die Substrattemperatur unter einem vorgegebenen Wert liegt.

Alternativ oder zusätzlich kann außerdem ein Sensor 26 am Hohlleiter 24 angeordnet sein, welcher die aus der Mikrowellen-Quelle 22 ausgekoppelte Leistung mißt. Auch dieser Sensor 26 ist mit der Steuereinrichtung 32 verbunden, so daß die Meßwerte des Sensors 26 in analoger Weise zur Meßeinrichtung 30 zur Steuerung der Länge der Pulsfolgen mittels der Steuereinrichtung 32 eingesetzt werden können.

Es ist dem Fachmann verständlich, daß die Erfindung nicht auf die vorstehend beschriebenen beispielhaften Ausführungsformen beschränkt ist, sondern vielmehr in vielfältiger Weise variiert werden kann. Insbesondere können die Merkmale der einzelnen Ausführungsbeispiele auch miteinander kombiniert oder einzelne spezielle Merkmale auch weggelassen werden.

## Patentansprüche

1. Verfahren zur Beschichtung von Substraten mittels plasmaunterstützter Dampfphasenabscheidung, wobei wenigstens ein Teil der Umgebung (13) der Substratoberfläche (14) eines zu beschichtenden Substrats (12) evakuiert und ein Prozessgas mit einer Ausgangssubstanz für die Beschichtung eingelassen wird, wobei die Beschichtung abgeschieden wird, indem durch Einstrahlung elektromagnetischer Energie in der Umgebung (13) der Substratoberfläche (14), die mit dem Prozessgas ausgefüllt ist, ein Plasma gezündet wird, wobei die elektromagnetische Energie in Form einer Vielzahl von Pulsfolgen (1), vorzugsweise Mikrowellen- oder Hochfrequenz-Pulsen, mit einer Vielzahl von zeitlich durch erste Pausen (t3) beabstandeten Pulsen (3) eingestrahlt wird, wobei in den Pausen (t3) die eingestrahlte elektromagnetische Energie abgeschaltet wird, und wobei die Pausen (t2) zwischen den Pulsfolgen (1) zumindest einen Faktor 3, vorzugsweise zumindest einen Faktor 5 länger sind als die ersten Pausen (t3) zwischen den Pulsen innerhalb einer Pulsfolge (1), **dadurch gekennzeichnet, daß**
die Pulsleistung oder zumindest eine von der Pulsleistung abhängige Größe gemessen und über die einzelnen Pulse (3) zeitlich integriert wird, wobei die Pulsfolge (1) mittels einer Steuereinrichtung abgebrochen wird, wenn die integrierte Pulsleistung einen vorbestimmten Schwellwert überschreitet und nach einer Pause (t2) die nächste Pulsfolge (1) gestartet wird.

2. Verfahren gemäß dem vorstehenden Anspruch, weiter **dadurch gekennzeichnet, daß**
die an einem Wellenleiter (24) zur Einkopplung der elektromagnetischen Energie ausgekoppelte Feldstärke gemessen und über die einzelnen Pulse (3) integriert wird.

3. Verfahren gemäß einem der beiden vorstehenden Ansprüche, weiter **dadurch gekennzeichnet, daß**
die Intensität der Lichtemission des Plasmas gemessen und zeitlich integriert wird, wobei die Pulsfolge (1) abgebrochen wird, wenn die zeitlich integrierte Lichtemission einen vorgegebenen Schwellwert überschreitet.

4. Verfahren gemäß einem der vorstehenden Ansprüche, weiter **dadurch gekennzeichnet, daß**
die Pulsleistung oder zumindest eine von der Pulsleistung abhängige Größe gemessen und über die einzelnen Pulse (3) zeitlich integriert wird, wobei die Länge der Pausen (t2) zwischen den Pulsfolgen (1) mittels einer Steuereinrichtung (32) anhand der gemessenen Größe angepasst wird.

5. Verfahren gemäß einem der vorstehenden Ansprüche, weiter **dadurch gekennzeichnet, daß**
die Substrattemperatur erfasst und anhand des erfassten Temperaturwerts die Länge der Pulsfolgen (1) oder das Verhältnis der Längen von Pausen (t2) zwischen den Pulsfolgen (1) und der Länge der Pulsfolge (t1) angepasst wird.

6. Verfahren gemäß dem vorstehenden Anspruch, weiter **dadurch gekennzeichnet, daß**
die Länge der Pulsfolgen (t1) verkürzt oder das Verhältnis von Länge der Pulsfolgen (t1) zu Länge der Pulspausen (t2) zwischen den Pulsfolgen (1) verkleinert wird, wenn die Substrattemperatur über einem vorgegebenen Wert liegt und/oder die Länge der Pulsfolge (t1) verlängert oder das Verhältnis von Länge der Pulsfolgen (t1) zu Länge der Pulspausen (t2) zwischen den Pulsfolgen (1) vergrößert wird, wenn die Substrattemperatur unter einem vorgegebenen Wert liegt.

7. Verfahren gemäß einem der vorstehenden Ansprüche, weiter **dadurch gekennzeichnet, dass** die Pulsleistung ungeregelt eingekoppelt wird.

8. Verfahren gemäß einem der vorstehenden Ansprüche, weiter **dadurch gekennzeichnet, daß**
die Pulse (3) in den Pulsfolgen (1) einen Dauer haben, die kürzer als 1/10 der Dauer einer Pulsfolge (t1) ist.

9. Verfahren gemäß einem der vorstehenden Ansprüche, weiter **dadurch gekennzeichnet, daß**
die Pulse (3) in den Pulsfolgen (1) eine Dauer von höchstens 5 Mikrosekunden, vorzugsweise höchstens 2 Mikrosekunden aufweisen.

10. Vorrichtung (10) zur Beschichtung von Substraten mittels plasmaunterstützter Dampfphasenabscheidung, insbesondere mittels eines Verfahrens gemäß einem der vorstehenden Ansprüche, umfassend
wenigstens einen Reaktor mit einer Einrichtung, um wenigstens einen Teil der Umgebung der Substratoberfläche (13) eines zu beschichtenden Substrats (14) zu evakuieren und ein Prozessgas mit einer Ausgangssubstanz für die Beschichtung einzulassen, und wobei die Vorrichtung (10) eine Quelle (22) für gepulste elektromagnetische Energie, vorzugsweise eine gepulst betriebene Mikrowellen- oder Hochfrequenzquelle aufweist, welche an den Reaktor angekoppelt ist, um durch Einstrahlung elektromagnetischer Energie in der Umgebung der Substratoberfläche (13), die mit dem Prozessgas ausgefüllt ist, ein Plasma zu zünden und eine Beschichtung abzuscheiden, wobei
die Vorrichtung (10) eine Steuereinrichtung (32) aufweist, die dazu eingerichtet ist, die gepulste Abstrahlung der elektromagnetischen Energie der Quelle (22) so zu steuern, daß die elektromagnetische Energie in Form einer Vielzahl von Pulsfolgen mit einer Vielzahl von zeitlich durch erste Pausen beabstandeten Pulsen eingestrahlt wird, wobei die Quelle in den ersten Pausen inaktiv geschaltet wird und wobei die Pausen zwischen den Pulsfolgen zumindest einen Faktor 3, vorzugsweise zumindest einen Faktor 5 länger sind als die Pausen zwischen den Pulsen innerhalb einer Pulsfolge, **dadurch gekennzeichnet, daß** die Vorrichtung (10) eine Meßeinrichtung (30) aufweist, mit welcher die Pulsleistung oder zumindest eine von der Pulsleistung abhängige Größe gemessen wird, wobei die Steuereinrichtung (32) ausgebildet ist, die Meßwerte über die einzelnen Pulse (3) zeitlich zu integrieren und die Pulsfolge (1) abzubrechen, wenn die integrierte Pulsleistung einen vorbestimmten Schwellwert überschreitet und nach einer Pause (t2) vorgegebener Länge die nächste Pulsfolge (1) zu starten.

11. Vorrichtung (10) gemäß dem vorstehenden Anspruch, weiter **dadurch gekennzeichnet, daß**
die Meßeinrichtung einen Sensor (26) umfasst, welcher an einem Wellenleiter (24) zur Einkopplung der elektromagnetischen Energie die ausgekoppelte Feldstärke misst.

12. Vorrichtung (10) gemäß einem der beiden vorstehenden Ansprüche, weiter **gekennzeichnet durch**
eine Einrichtung zur Messung der Lichtintensität des Plasmas, wobei die Steuereinrichtung (32) eingerichtet ist, eine Pulsfolge (1) abzubrechen, wenn die zeitlich integrierte Intensität der Lichtemission einen vorgegebenen Schwellwert überschreitet.

13. Vorrichtung (10) gemäß einem der vorstehenden Ansprüche 10 bis 12, weiter **dadurch gekennzeichnet, daß** eine Meßeinrichtung (30) vorgesehen ist, mit welcher die Pulsleistung oder zumindest eine von der Pulsleistung abhängige Größe meßbar ist, wobei die Steuereinrichtung (30) eingerichtet ist, die gemessenen Größe über die einzelnen Pulse (3) zeitlich zu integrieren, und die Länge der Pausen (t2) zwischen den Pulsfolgen (1) anhand der integrierten gemessenen Größe anzupassen.

14. Vorrichtung (10) gemäß einem der vorstehenden Ansprüche 10 bis 13, weiter **gekennzeichnet durch** eine Meßeinrichtung (30) zur Erfassung der Substrattemperatur, wobei die Steuereinrichtung (32) angepasst ist, anhand des erfassten Temperaturwerts die Länge der Pulsfolgen (t1) anzupassen.

15. Vorrichtung (10) gemäß dem vorstehenden Anspruch, weiter **dadurch gekennzeichnet, daß** die Steuereinrichtung (32) eingerichtet ist, die Länge der Pulsfolgen (t1) zu verkürzen oder das Verhältnis von Länge der Pulsfolgen (t1) zu Länge der Pulspausen (t2) zwischen den Pulsfolgen (1) zu verkleinern, wenn die Substrattemperatur über einem vorgegebenen Wert liegt und/oder die Länge der Pulsfolge (1) zu verlängern oder das Verhältnis von Länge der Pulsfolgen (t2) zu Länge der Pulspausen (t2) zwischen den Pulsfolgen (1) zu vergrößern, wenn die Substrattemperatur unter einem vorgegebenen Wert liegt.

16. Vorrichtung gemäß einem der vorstehenden Ansprüche 10 bis 15, weiter **gekennzeichnet durch** eine Quelle mit ungeregelter Leistungsabgabe.

## Claims

1. A method for coating substrates using plasma-assisted vapor deposition, wherein at least part of the environment (13) of the substrate surface (14) of a substrate (12) to be coated is evacuated, and a process gas including a starting substance for the coating is introduced, the coating being deposited by igniting a plasma by irradiating electromagnetic energy into the environment (13) of the substrate surface (14) filled with the process gas;
wherein the electromagnetic energy is irradiated in form of a plurality of pulse trains (1) of preferably microwave or radio frequency pulses comprising a plurality of pulses (3) spaced in time by first intervals (t3), wherein during the intervals (t3) the irradiated electromagnetic energy is turned off, and wherein pauses (t2) between the pulse trains (1) are longer by at least a factor of 3, preferably at least a factor of 5, than the first intervals (t3) between the pulses within a pulse train (1), **characterized in that** the pulse power is measured, or at least a quantity that is a function of the pulse power, and is time-integrated over the individual pulses (3), wherein the pulse train (1) is stopped by a control device, when the integrated pulse power exceeds a predetermined threshold, and wherein the next pulse train (1) is started after a pause (t2).

2. The method according to the preceding claim, further **characterized in that** the field strength emitted from a waveguide (24) for injecting the electromagnetic energy is measured and is integrated over the individual pulses (3).

3. The method according to any of the two preceding claims, further **characterized in that** the intensity of light emission of the plasma is measured and integrated over time, wherein the pulse train (1) is stopped when the time-integrated light emission exceeds a predetermined threshold.

4. The method according to any of the preceding claims, further **characterized in that** the pulse power is measured, or at least a quantity that is a function of the pulse power, and is time-integrated over the individual pulses (3), wherein the duration of the pauses (t2) between the pulse trains (1) is adjusted by a control device (32) based on the measured quantity.

5. The method according to any of the preceding claims, further **characterized in that** the substrate temperature is detected, and that based on the detected temperature value, the duration of the pulse trains (1) or the ratio of the duration of pauses (t2) between the pulse trains (1) to the duration of the pulse train (t1) is adjusted.

6. The method according to the preceding claim, further **characterized in that** the duration of the pulse trains (t1) is shortened or the ratio of the duration of the pulse trains (t1) to the duration of the pulse pauses (t2) between the pulse trains (1) is decreased when the substrate temperature exceeds a predetermined value; and/or that the duration of the pulse train (t1) is extended or the ratio of the duration of the pulse trains (t1) to the duration of the pulse pauses (t2) between the pulse trains (1) is increased when the substrate temperature is below a predetermined value.

7. The method according to any of the preceding claims, further **characterized in that** the pulse power is injected without feedback control.

8. The method according to any of the preceding claims, further **characterized in that** the duration of the pulses (3) in the pulse trains (1) is shorter than 1/10 of the duration of a pulse train (t1).

9. The method according to any of the preceding claims, further **characterized in that** the duration of the pulses (3) in the pulse trains (1) is not more than 5 microseconds, preferably not more than 2 microseconds.

10. An apparatus (10) for coating substrates using plasma-assisted vapor deposition, in particular by using a method as claimed in any of the preceding claims, comprising:
at least one reactor including a means for evacuating at least part of the environment of the substrate surface (13) of a substrate (14) to be coated and for introducing a process gas including a starting substance for the coating, and wherein said apparatus (10) comprises a source (22) for pulsed electromagnetic energy, preferably a microwave or radio frequency source operated in pulsed mode, which is coupled to the reactor to ignite a plasma in the environment of the substrate surface (13) which is filled with the process gas by irradiating electromagnetic energy for depositing a coating;
wherein the apparatus (10) comprises a control means (32) adapted for controlling pulsed emission of the electromagnetic energy from the source (22) in a manner so that the electromagnetic energy is irradiated in form of a plurality of pulse trains each comprising a plurality of pulses spaced in time by first intervals, wherein the source is disabled during the first intervals, and wherein the pauses between the pulse trains are longer by at least by a factor of 3, preferably at least a factor of 5, than the intervals between the pulses within a pulse train;
**characterized in that** the apparatus (10) comprises a measuring means (30) used for measuring the pulse power or at least a quantity that is a function of the pulse power, wherein said control means (32) is adapted to time-integrate the measured values over the individual pulses (3) and to stop the pulse train (1) when the integrated pulse power exceeds a predetermined threshold, and to start the next pulse train (1) after a pause (t2) of predetermined duration.

11. The apparatus (10) according to the preceding claim, further **characterized in that** the measuring means comprises a sensor (26) which measures the field strength emitted from a waveguide (24) for injecting the electromagnetic energy.

12. The apparatus (10) according to any of the two preceding claims, further **characterized by** a means for measuring the light intensity of the plasma, wherein said control means (32) is adapted to stop a pulse train (1) when the time-integrated intensity of light emission exceeds a predetermined threshold.

13. The apparatus (10) according to any of the preceding claims 10 to 12, further **characterized in that** a measuring means (30) is provided, which can be used to measure the pulse power or at least a quantity that is a function of the pulse power, wherein said control means (32) is adapted to time-integrate the measured quantity over the individual pulses (3) and to adjust the duration of the pauses (t2) between the pulse trains (1) based on the integrated measured quantity.

14. The apparatus (10) according to any of the preceding claims 10 to 13, further **characterized by** a measuring means (30) for detecting the substrate temperature, wherein said control means (32) is adapted to adjust the duration of the pulse trains (1) based on the detected temperature value.

15. The apparatus (10) according to the preceding claim, further **characterized in that** said control means (32) is adapted to reduce the duration of the pulse trains (t1) or to decrease the ratio of the duration of the pulse trains (t1) to the duration of the pulse pauses (t2) between the pulse trains (1) when the substrate temperature exceeds a predetermined value; and/or to extend the duration of the pulse train (1) or to increase the ratio of the duration of the pulse trains (t1) to the duration of the pulse pauses (t2) between the pulse trains (1) when the substrate temperature is below a predetermined value.

16. The apparatus according to any of the preceding claims 10 to 15, further **characterized by** a source for power output without feedback control.

## Revendications

1. Procédé de revêtement de substrats par dépôt en phase vapeur assisté par plasma, au moins une partie de l'environnement (13) de la surface (14) d'un substrat (12) à revêtir étant soumise à un vide et un gaz de processus étant appliqué avec un agent précurseur pour le revêtement, le revêtement étant déposé en allumant un plasma par rayonnement d'énergie électromagnétique dans l'environnement (13) de la surface (14) du substrat saturée de gaz de processus, l'énergie électromagnétique étant irradiée sous la forme d'une pluralité de séquences d'impulsions (1), préférentiellement des impulsions à hautes fréquences ou à hyperfréquences, avec une pluralité d'impulsions (3) temporellement séparées par de premières pauses (t3), l'énergie électromagnétique irradiée étant coupée pendant les pauses (t3), et les pauses (t2) entre les séquences d'impulsions (1) étant au moins 3 fois, préférentiellement au moins 5 fois, plus longues que les premières pauses (t3) entre les impulsions à l'intérieur d'une séquence d'impulsions (1), **caractérisé en ce que** :
la puissance pulsée ou au moins une grandeur dépendante de la puissance pulsée est mesurée et temporellement intégrée aux différentes impulsions (3), la séquence d'impulsions (1) étant interrompue au moyen d'un dispositif de commande quand la puissance pulsée intégrée dépasse une valeur seuil prédéfinie, et la séquence d'impulsions (1) suivante étant lancée après une pause (t2).

2. Procédé selon la revendication précédente, **caractérisé en outre en ce que** l'intensité de champ découplée sur un guide d'ondes (24) pour le couplage de l'énergie électromagnétique est mesurée et intégrée aux différentes impulsions (3).

3. Procédé selon l'une des deux revendications précédentes, **caractérisé en outre en ce que** l'intensité d'émission lumineuse du plasma est mesurée et temporellement intégrée, la séquence d'impulsions (1) étant interrompue quand l'émission lumineuse temporellement intégrée dépasse une valeur seuil prédéfinie.

4. Procédé selon l'une des revendications précédentes, **caractérisé en outre en ce que** la puissance pulsée ou au moins une grandeur dépendante de la puissance pulsée est mesurée et temporellement intégrée aux différentes impulsions (3), la longueur des pauses (t2) entre les séquences d'impulsions (1) étant ajustée par un dispositif de commande (32) sur la base de la grandeur mesurée.

5. Procédé selon l'une des revendications précédentes, **caractérisé en outre en ce que** la température du substrat est détectée, et **en ce que** la longueur des séquences d'impulsions (1) ou le rapport entre les longueurs des pauses (t2) entre les séquences d'impulsions (1) et la longueur de la séquence d'impulsions (t1) sont ajustés sur la base de la valeur de température détectée.

6. Procédé selon la revendication précédente, **caractérisé en outre en ce que** la longueur des séquences d'impulsions (t1) est raccourcie, ou le rapport entre la longueur des séquences d'impulsions (t1) et la longueur des pauses d'impulsions (t2) entre les séquences d'impulsions (1) est réduit, quand la température du substrat est supérieure à une valeur prédéfinie et/ou la longueur de la séquence d'impulsions (t1) est augmentée, ou le rapport entre la longueur des séquences d'impulsions (t1) et la longueur des pause d'impulsions (t2) entre les séquences d'impulsions (1) est augmenté, quand la température du substrat est inférieure à une valeur prédéfinie.

7. Procédé selon l'une des revendications précédentes, **caractérisé en outre en ce que** la puissance pulsée est couplée sans régulation.

8. Procédé selon l'une des revendications précédentes, **caractérisé en outre en ce que** les impulsions (3) des séquences d'impulsions (1) ont une durée inférieure à 1/10^{e} de la durée d'une séquence d'impulsions (t1).

9. Procédé selon l'une des revendications précédentes, **caractérisé en outre en ce que** les impulsions (3) des séquences d'impulsions (1) ont une durée maximale de 5 microsecondes, préférentiellement de 2 microsecondes au maximum.

10. Dispositif (10) pour le revêtement de substrats par dépôt en phase vapeur assisté par plasma, en particulier au moyen d'un procédé selon l'une des revendications précédentes, comprenant :
au moins un réacteur avec un dispositif, pour soumettre à un vide au moins une partie de l'environnement de la surface (13) d'un substrat (14) à revêtir et appliquer un gaz de processus avec un agent précurseur pour le revêtement, et le dispositif (10) comportant une source (22) pour l'énergie électromagnétique pulsée, préférentiellement une source de hautes fréquences ou d'hyperfréquences pulsées couplée au réacteur, pour allumer un plasma par rayonnement d'énergie électromagnétique dans l'environnement de la surface (13) du substrat saturée de gaz de processus, et déposer un revêtement, le dispositif (10) comportant un dispositif de commande (32) prévu pour commander le rayonnement pulsé de l'énergie électromagnétique de la source (22) de manière à irradier l'énergie électromagnétique sous la forme d'une pluralité de séquences d'impulsions avec une pluralité d'impulsions temporellement séparées par de premières pauses, la source étant désactivée pendant les premières pauses et les pauses entre les séquences d'impulsions étant au moins 3 fois, préférentiellement au moins 5 fois, plus longues que les pauses entre les impulsions à l'intérieur d'une séquence d'impulsions,
le dispositif (10) étant **caractérisé en ce qu'**il comporte un dispositif de mesure (30) permettant de mesurer la puissance pulsée ou au moins une grandeur dépendante de la puissance pulsée, le dispositif de commande (32) étant prévu pour intégrer temporellement les valeurs de mesure aux différentes impulsions (3) et pour interrompre la séquence d'impulsions (1) quand la puissance pulsée intégrée dépasse une valeur seuil prédéfinie, et pour lancer la séquence d'impulsions (1) suivante après une pause (t2) de longueur prédéfinie.

11. Dispositif (10) selon la revendication précédente, **caractérisé en outre en ce que** le dispositif de mesure comprend un capteur (26) qui mesure sur un guide d'ondes (24) l'intensité de champ découplée pour le couplage de l'énergie électromagnétique.

12. Dispositif (10) selon l'une des deux revendications précédentes, **caractérisé en outre par** un dispositif de mesure de l'intensité lumineuse du plasma, le dispositif de commande (32) étant prévu pour interrompre une séquence d'impulsions (1) quand l'intensité temporellement intégrée de l'émission lumineuse dépasse une valeur seuil prédéfinie.

13. Dispositif (10) selon l'une des revendications 10 à 12, **caractérisé en outre en ce qu'**un dispositif de mesure (30) est prévu, permettant de mesurer la puissance pulsée ou au moins une grandeur dépendante de la puissance pulsée, le dispositif de commande (30) étant prévu pour intégrer temporellement la grandeur mesurée aux différentes impulsions (3), et pour ajuster la longueur des pauses (t2) entre les séquences d'impulsions (1) sur la base de la grandeur mesurée intégrée.

14. Dispositif (10) selon l'une des revendications 10 à 13, **caractérisé en outre par** un dispositif de mesure (30) pour la détection de la température du substrat, le dispositif de commande (32) étant prévu pour ajuster la longueur des séquences d'impulsions (t1) sur la base de la valeur de température détectée.

15. Dispositif (10) selon la revendication précédente, **caractérisé en outre en ce que** le dispositif de commande (32) est prévu pour raccourcir la longueur des séquences d'impulsions (t1) ou réduire le rapport entre la longueur des séquences d'impulsions (t1) et la longueur des pause d'impulsions (t2) entre les séquences d'impulsions (1), quand la température du substrat est supérieure à une valeur prédéfinie, et/ou pour augmenter la longueur de la séquence d'impulsions (1), ou le rapport entre la longueur des séquences d'impulsions (t1) et la longueur des pauses d'impulsions (t2) entre les séquences d'impulsions (1), quand la température du substrat est inférieure à une valeur prédéfinie.

16. Dispositif selon l'une des revendications 10 à 15, **caractérisé en outre par** une source émettant une puissance non régulée.
